# FASCICULE DE BREVET EUROPEEN

(11) **EP 1 251 581 B1**
(45) Date de publication et mention de la délivrance du brevet: **14.05.2008**
(21) Numéro de dépôt: 02354061.0
(22) Date de dépôt: 17.04.2002
(51) Int. Cl.: H01P 3/08, H01Q 13/20, H01L 23/64, H01L 21/02

(54) **Enroulement inductif intégré haute fréquence**
Hochfrequenz integrierte induktive Spule
High frequency integrated inductive coil

(30) Priorité: 20.04.2001 FR 0105403
(43) Date de publication de la demande: 23.10.2002
(73) Titulaire: STMicroelectronics S.A., 92120 Montrouge (FR)
(72) Inventeur: Farcy, Alexis, 73490 La Ravoire (FR); Arnal, Vincent, 38000 Grenoble (FR); Torres, Joaquim, 38950 St Martin le Vinoux (FR)
(74) Mandataire: de Beaumont, Michel

(56) Documents cités:
- EP-A- 1 079 458
- US-A- 4 442 590

## Description

La présente invention concerne, de façon générale, la réalisation d'enroulements inductifs (inductances) sur une puce de circuit intégré. Plus particulièrement, la présente invention concerne la réalisation d'inductances destinées à recevoir des courants haute fréquence, telles que, par exemple, des antennes haute fréquence de téléphones mobiles ou des filtres.

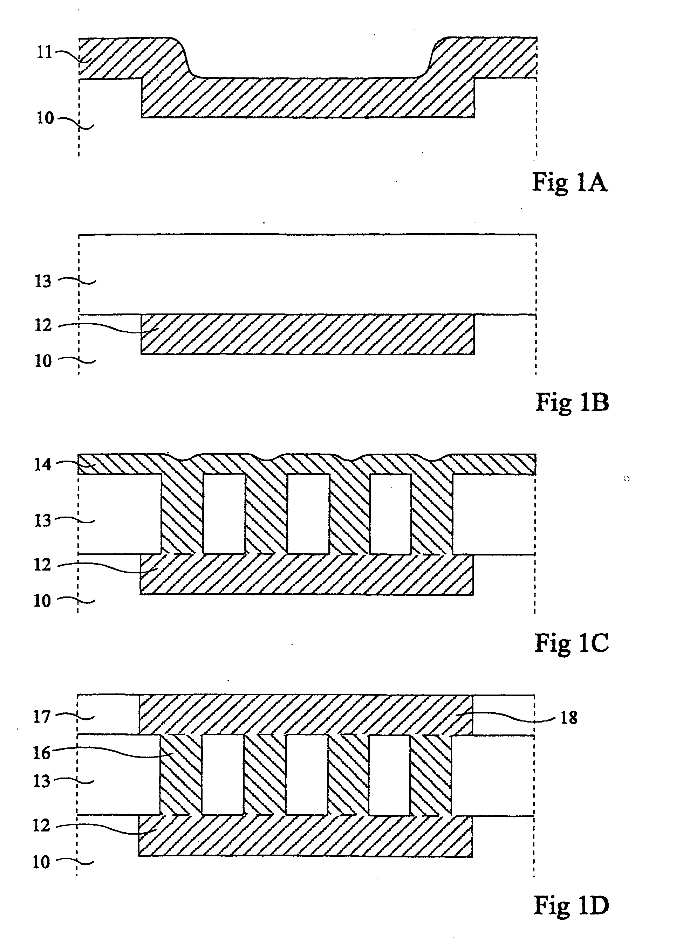

Les figures 1A à 1D illustrent, en vue en coupe schématique et partielle, la formation d'une inductance selon une séquence d'étapes classiquement mises en oeuvre. Plus particulièrement, les figures 1A à 1D sont des vues en coupe selon la largeur d'une spire de l'inductance.

Comme l'illustre la figure 1A, on commence par ouvrir une tranchée dans une couche isolante 10 selon le motif de l'inductance. On dépose ensuite une couche d'un matériau conducteur 11 de façon à remplir complètement la tranchée précédemment ouverte.

Aux étapes suivantes, illustrées en figure 1B, on grave la couche 11 de façon à l'éliminer de la surface supérieure de la couche isolante 10. Pour ce faire, on procède à un polissage mécano-chimique (CMP). On a ainsi formé un premier niveau conducteur horizontal 12. Comme cela a été exposé précédemment, la figure 1 est une vue en coupe selon la largeur d'une spire de l'inductance. Le premier niveau 12 s'étend sur tout le motif de l'inductance, et est commun à toutes ses spires. Ensuite, on dépose une couche isolante 13. La couche 13 est déposée de façon que sa surface supérieure est sensiblement plane.

Comme l'illustre la figure 1C, on forme dans la couche 13 des ouvertures distinctes de façon à découvrir partiellement différentes portions de la surface supérieure du premier niveau 12. Ensuite, ces ouvertures sont remplies par un matériau conducteur 14, de préférence identique au matériau conducteur 11 constituant le premier niveau 12.

Après dépôt sur l'ensemble de la structure du matériau 14, on procède à un polissage mécano-chimique afin d'éliminer le matériau 14 de la surface supérieure de la couche isolante 13.

On individualise ainsi, comme l'illustre la figure 1D, des vias conducteurs parallèles 16 en contact avec le premier niveau 12. Ensuite, on dépose une couche isolante 17 de façon que sa surface supérieure soit sensiblement plane. On forme ensuite un deuxième niveau conducteur horizontal 18 à la verticale du premier niveau 12 et interconnectant tous les vias 16. Le deuxième niveau 18 est formé en ouvrant une tranchée selon un motif approprié dans la couche isolante 17, puis en déposant un matériau conducteur de préférence identique au matériau conducteur 11 et enfin en procédant à un polissage mécano-chimique (CMP) de façon à ne maintenir en place le cuivre que dans la tranchée précédemment formée.

On forme ainsi, dans une puce de circuits intégrés, une inductance dont les spires comportent des premier et deuxième niveaux conducteurs horizontaux 12 et 18 interconnectés par des vias 16. Des lignes ou vias d'interconnexions peuvent être réalisés dans les couches isolantes 10, 13 et/ou 17 simultanément au premier niveau 12, aux vias 16 et/ou au deuxième niveau 18.

Dans des applications de type télécommunication, des inductances sont par contre disposées au-dessus de circuits intégrés, aucun autre élément conducteur n'étant formé dans les couches isolantes 10, 13 et 17. De telles inductances, destinées à servir d'antenne dans des dispositifs haute fréquence, doivent présenter un facteur de qualité Q maximal et pouvoir travailler à une fréquence de résonance optimale et/ou dans une bande de fréquence la plus large possible.

Augmenter le facteur Q conduit à réduire la résistance de l'inductance. Pour ce faire, on a déjà proposé d'utiliser comme matériau conducteur constituant les niveaux 12 et 18 et les vias 16 des matériaux faiblement résistifs tels que du cuivre ou des alliages à base de cuivre. Pour réduire encore la résistivité, on a ensuite proposé d'accroître la surface des niveaux 12 et 18 et des vias 16. Cette augmentation étant impossible dans l'épaisseur des couches successives 10, 13, 17 fixée par d'autres contraintes standard des procédés de la micro-électronique, on a formé dans les couches 10 et 17 des niveaux 12 et 18 les plus larges possible, en augmentant de façon correspondante le nombre de vias 16 dans la couche 13. Toutefois, un tel accroissement de largeur des niveaux 12 et 18 est limité du fait du polissage mécano-chimique mis en oeuvre pour individualiser les spires dans chaque couche. En effet, lors d'un polissage CMP d'une surface relativement étendue de cuivre, on observe une consommation de cette surface, c'est-à-dire la formation d'un creux dont la profondeur et l'étendue sont mal définies. La résistance réelle de la ligne parcourue par un courant donné est alors accrue et le facteur de qualité Q diminué. Cette diminution du facteur de qualité Q est incontrôlée. En outre, si la surface est trop importante, cette déformation peut aller jusqu'à un arrachage de la ligne conductrice. Il en résulte une rupture de la spire.

Un autre inconvénient d'un élargissement des niveaux 12 et 18 réside dans l'impact négatif sur les performances électriques résultantes. En effet, lorsque l'inductance ainsi réalisée est parcourue par un courant donné, celui-ci génère un champ magnétique qui donne lui-même naissance à un courant inverse, dit courant de Foucault. Ce courant inverse correspond à un accroissement de la résistance réelle. Or, ce courant de Foucault est proportionnel à la largeur de la spire, et non à son épaisseur ou à sa longueur. Augmenter la largeur de la spire conduit donc à un accroissement de la résistance réelle et à une diminution correspondante du facteur de qualité Q.

En outre, lorsque l'on tente de faire passer dans un conducteur un courant électrique de fréquence élevée, le courant tend à ne circuler qu'à la périphérie du volume conducteur (effet de peau). En d'autres termes, pour des courants de fréquence élevée, au lieu de profiter de toute la surface conductrice, le courant se limite à une faible surface périphérique. Le courant étant de fréquence relativement élevée, tout se passe comme si le courant circulait dans un conducteur de résistance réelle élevée. Le facteur de qualité est encore abaissé. Par conséquent, la plage de fréquence, c'est-à-dire la fréquence maximale qui peut être atteinte par un courant circulant dans une telle inductance, est limitée.

A l'heure actuelle, compte tenu des divers problèmes exposés précédemment, les inductances supportent des courants d'une fréquence d'au plus 50 Hz.

Parallèlement, la volonté de transmettre un nombre d'informations de plus en plus élevé et l'encombrement des plages de fréquence conduit à rechercher des systèmes de communication propres à fonctionner à des fréquences les plus élevées possibles avec des facteurs de qualité optimisés.

La présente invention vise par conséquent à proposer une inductance formée dans une puce de circuits intégrés dont le facteur de qualité soit parfaitement contrôlé.

La présente invention vise à proposer une telle inductance dont la bande de fréquence soit relativement élevée.

La présente invention vise également à proposer une telle inductance dont la fabrication s'inscrive dans la séquence d'étapes couramment mises en oeuvre dans la fabrication des métallisations d'un circuit intégré.

Pour atteindre ces objets, la présente invention prévoit une inductance réalisée dans une puce de circuit intégré, constituée d'une pluralité de lignes conductrices parallèles entre elles, de largeur optimisée, chaque ligne conductrice étant formée dans l'épaisseur d'au moins une couche isolante, ces lignes étant interconnectées par au moins un segment conducteur perpendiculaire.

Selon un mode de réalisation de la présente invention, la largeur optimisée est égale au double de l'épaisseur de peau correspondant à la fréquence maximale d'un courant haute fréquence passant dans ladite inductance.

Selon un mode de réalisation de la présente invention, les lignes conductrices sont formées dans trois couches isolantes et les segments conducteurs sont formés dans au moins une des trois couches isolantes.

La présente invention vise aussi un procédé de formation d'une inductance sous forme monolithique, comportant l'étape consistant à former dans au moins une couche isolante, le long du motif de l'inductance, une pluralité de lignes conductrices parallèles et des segments perpendiculaires auxdites lignes et les interceptant toutes.

Selon un mode de réalisation de la présente invention, les lignes conductrices ont une largeur égale au double de l'épaisseur de peau correspondant à la fréquence maximale d'un courant haute fréquence destiné à passer dans l'inductance.

Selon un mode de réalisation de la présente invention, une quelconque étape de formation et/ou d'extension de lignes conductrices dans une couche isolante comporte les étapes consistant à creuser dans la couche isolante considérée des tranchées selon le motif souhaité ; déposer une couche d'un matériau conducteur de façon à remplir les tranchées ; et procéder à un polissage mécano-chimique, de façon à éliminer ledit matériau conducteur de la surface supérieure de ladite couche isolante considérée, d'où il résulte que le matériau conducteur ne demeure en place que dans les tranchées précédemment formées.

Selon un mode de réalisation de la présente invention, le matériau conducteur est métallique, par exemple du cuivre ou un alliage à base de cuivre.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A à 1D illustrent, en vue en coupe partielle et schématique, différentes étapes de fabrication d'une inductance selon des procédés classiques ;
les figures 2A à 2C illustrent, en vue en coupe partielle et schématique, des étapes de la formation d'une inductance selon la présente invention ; et
la figure 3 illustre, en vue de dessus agrandie, une partie d'une inductance selon la présente invention.

Par souci de clarté, les mêmes références désignent aux différentes figures les mêmes éléments. En outre, comme cela est habituel dans le domaine de la représentation de circuits intégrés, les différentes figures ne sont pas à l'échelle.

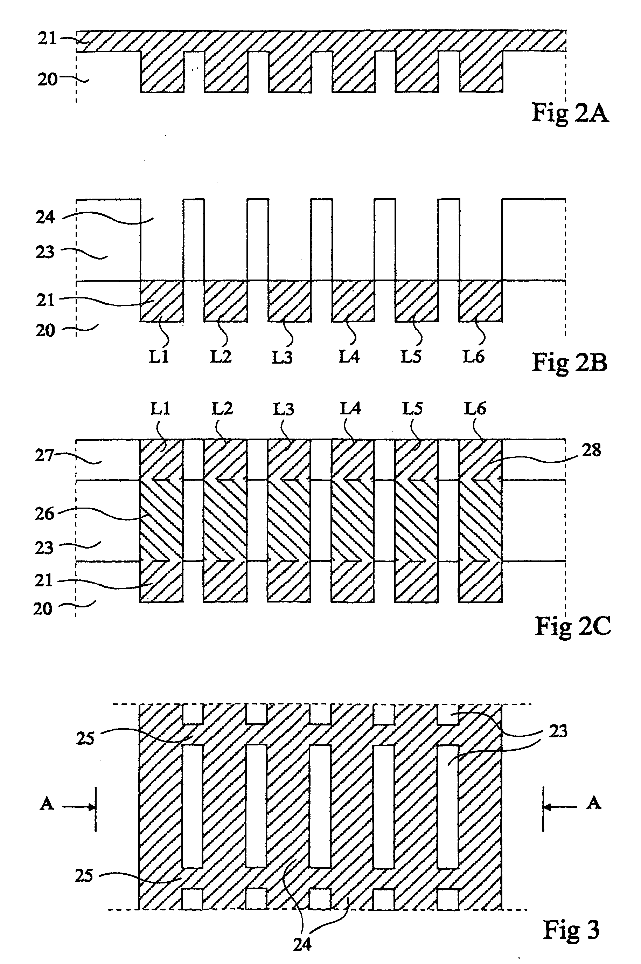

Les figures 2A, 2B et 2C illustrent, en vue en coupe schématique et partielle, la section d'une spire d'une inductance selon l'invention en cours de fabrication.

La formation d'une inductance selon l'invention commence, comme l'illustre la figure 2A, par l'ouverture, dans une couche isolante 20, de plusieurs tranchées parallèles, par exemple six, selon le motif de l'inductance. La couche isolante 20 est superposée à un substrat semiconducteur (non représenté) dans et sur lequel sont intégrés divers éléments. La somme des largeurs individuelles de ces tranchées est égale à la largeur voulue pour une spire de l'inductance. La largeur individuelle de chaque tranchée est optimisée de la façon détaillée ci-après.

Les tranchées ainsi formées sont ensuite remplies en déposant sur l'ensemble de la structure un matériau conducteur 21, de préférence métallique, par exemple du cuivre. Par rapport à un procédé classique, l'épaisseur de la couche 21 est nettement inférieure à l'épaisseur de la couche homologue (11, figure 1A). En effet, le remplissage d'une série de tranchées parallèles de largeur optimisée est plus rapide que le remplissage d'une unique grande ouverture, pour une même surface de base totale. Le remplissage des tranchées parallèles survient donc alors qu'une épaisseur moindre de cuivre 21 a été déposée sur la couche 20.

Le matériau 21 est ensuite éliminé de la surface supérieure de l'isolant 20 par polissage mécano-chimique. Cette élimination s'effectue plus facilement que celle de la couche homologue de l'art antérieur. En effet, d'une part l'épaisseur de la couche 21 est moindre et, d'autre part, les risques de creusement ou d'arrachage du matériau 21 dans les tranchées sont limités par leur faible surface et l'alternance de ce matériau 21 et des parties de l'isolant 20 séparant deux tranchées consécutives.

On forme ainsi, comme l'illustre la figure 2B, six lignes conductrices parallèles distinctes L1, L2, L3, L4, L5 et L6. Aux étapes suivantes, on dépose une couche isolante 23 de façon que sa surface supérieure soit plane. La couche isolante 23 est ensuite creusée selon le motif de tranchée décrit ci-après en relation avec la figure 3. Une première série de tranchées 24 permet de découvrir la surface supérieure de chacune des six lignes conductrices L1 à L6 précédemment formées. Ces tranchées 24, comme l'illustrent les figures 2B et 3, sont disjointes et parallèles entre elles. Perpendiculairement à ces premières tranchées 24, on forme des deuxièmes tranchées 25 qui interceptent toutes les premières tranchées 24. Les tranchées 25 s'étendent donc sur toute la largeur de la spire. La largeur des tranchées 25 est minimisée. La figure 2B correspond à une coupe selon l'axe A-A de la figure 3, parallèle et distinct des tranchées 25.

On dépose ensuite, comme l'illustre la figure 2C, un matériau conducteur 26, de façon à remplir les premières tranchées 24 et les deuxièmes tranchées perpendiculaires 25. Ceci est effectué en déposant sur l'ensemble de la structure le matériau 26 puis en mettant en oeuvre un polissage CMP afin d'éliminer le matériau 26 en dehors des tranchées 24 et 25. On a ainsi prolongé, dans la couche 23, les six lignes L1 à L6. En outre, on a réalisé, en remplissant les deuxièmes tranchées 25, une interconnexion électrique entre ces différentes lignes. Enfin, l'ensemble des étapes décrites précédemment est répété afin de prolonger encore les lignes conductrices L1 à L6 dans une couche isolante 27 en déposant un matériau conducteur 28.

On a ainsi formé une spire d'une inductance constituée d'une pluralité de lignes parallèles, par exemple six L1, L2, L3, L4, L5 et L6. Ces lignes L1 à L6 s'étendent sur toute la longueur de l'inductance. La largeur des lignes L1, L2, L3, L4, L5 et L6 est optimisée dans la technologie considérée pour une fréquence donnée en fonction des contraintes suivantes. D'une part, les lignes L1 à L6 doivent être aussi large que possible pour minimiser leur résistance statique. D'autre part, les lignes L1 à L6 doivent être aussi réduites que nécessaire pour réduire l'augmentation de la résistance aux fréquences élevées. Pour une fréquence d'utilisation maximale donnée, la largeur des tranchées doit alors être au plus égale au double de l'épaisseur de peau correspondante. La largeur est de préférence égale à cette valeur limite, pour minimiser la résistance statique. Toutefois, si la fréquence maximale possible est trop élevée, la largeur sera rendue aussi proche de cette limite que le permettent les procédés de formation de tranchées dans une couche isolante 20, 23, 22 et les procédés de dépôt d'un matériau conducteur peu résistif 22, 26, 28.

Les différentes lignes disjointes L1 à L6 sont interconnectées par des segments conducteurs orthogonaux à ces lignes, formés au moins dans la couche intermédiaire 23 par le remplissage des tranchées 25. L'objet de ces segments orthogonaux est de former une spire unique à partir des lignes L1 à L6. Ces segments orthogonaux ou ponts permettent également d'assurer une homogénéité des potentiels dans les différentes lignes L1 à L6 pour éviter un couplage capacitif.

En outre, pour réduire la densité du matériau 26 avant polissage par CMP, on prévoira aussi peu de segments orthogonaux ou ponts que nécessaire pour assurer une équipartition des courants circulant dans les lignes L1 à L6.

Selon une variante non représentée, les ponts sont formés non seulement dans la couche intermédiaire 23, mais également dans l'une et/ou l'autre des couches inférieure 20 et supérieure 27.

Selon une variante non représentée, les ponts ne sont pas formés dans la couche intermédiaire 23, mais seulement dans l'une et/ou l'autre des couches inférieure 20 et supérieure 27.

En outre, on a décrit à titre d'exemple non-limitatif des lignes conductrices L1 à L6 réalisées dans trois niveaux conducteurs. Elles pourraient être réalisées dans plus ou moins de trois niveaux. Toutefois, dans au moins un de ces niveaux seront formés les ponts les interceptant toutes.

Selon un mode de réalisation, les matériaux conducteurs peu résistifs constituant les couches 22, 26, 28 sont identiques. De préférence, on choisira un matériau métallique tel que du cuivre ou un alliage à base de cuivre.

Les avantages d'un tel procédé sont multiples. Tout d'abord l'individualisation de diverses lignes L1 à L6 par polissage CMP est facilitée par rapport à un procédé standard. Chaque portion de cuivre présente une largeur réduite, qu'il s'agisse des lignes L1 à L6 et/ou des ponts, et est noyée dans un isolant. L'abaissement correspondant de la densité de cuivre élimine, sinon diminue fortement, les risques de creusement et/ou d'arrachage.

Un autre avantage de ce procédé réside en ce qu'il est maintenant possible d'élargir autant que l'on souhaite la largeur de la spire. En effet, cet élargissement de la spire se traduit par une augmentation du nombre de lignes parallèles interconnectées par des ponts. Ceci peut s'effectuer sans risquer d'endommager les lignes et/ou les ponts lors de leur individualisation par polissage CMP.

Un autre avantage d'une telle structure réside en ce que les courants de Foucault proportionnels à la largeur des spires sont considérablement réduits par rapport aux courants de Foucault existant dans les structures existantes. En effet, on a supprimé les premier et deuxième niveaux conducteurs horizontaux (12, 18, figure 1) de grande largeur.

Ceci permet avantageusement d'accroître l'intensité des courants circulant dans la spire. En effet, l'accroissement correspondant du champ magnétique induit provoque des courants de Foucault plus faibles que ceux qui seraient induits dans une structure standard.

De même, la structure selon l'invention présente l'avantage de permettre un accroissement de la fréquence des courants circulant dans la spire. Cet effet sera optimisé en réalisant des lignes L1 à L6 dont la largeur est inférieure au double de l'épaisseur de peau. La fréquence maximale possible est alors limitée par les seules contraintes des procédés de formation de tranchées dans une couche isolante 20, 23, 22 et des procédés de dépôt d'un matériau conducteur peu résistif 22, 26, 28.

Ainsi, en supposant que les différentes couches isolantes 20, 23 et 27 ont une épaisseur comprise entre 1 et 10 µm, par exemple de l'ordre de 4 µm, il est possible de réduire la largeur des tranchées à l'heure actuelle jusqu'à une dimension comprise entre 0,2 et 5 µm, par exemple de l'ordre de 1 µm. Alors, chaque ligne L1 à L6 est totalement parcourue par un courant tant que sa fréquence est inférieure à 20 GHz. L'effet de peau n'apparaît qu'au-delà. Alors, la résistance est constante, indépendante de la fréquence sur une plage de fréquence beaucoup plus large que dans les dispositifs standards tels que décrits précédemment en relation avec la figure 1. Cette plage pourra s'étendre jusqu'à environ 100 GHz sans affecter la qualité des informations transmises.

Bien entendu, la présente invention est susceptible de diverses variantes et modifications qui apparaîtront à l'homme de l'art. En particulier, quand des exemples numériques ont été donnés, ces exemples numériques n'ont pas pour objet de limiter la présente invention à de tels exemples. Notamment, la largeur des diverses tranchées sera réduite à l'optimum souhaitable en fonction des procédés de formation de tranchées dans une couche isolante et de remplissage de telles tranchées par un matériau peu résistif. De même, le nombre de lignes conductrices sera accru, le cas échéant, afin de permettre le passage de courants aussi élevés que possible.

Par ailleurs, l'homme de l'art saura réaliser, le cas échéant, dans chacune des diverses couches isolantes 20, 23, 27, en dehors de la région de formation de l'inductance, tout autre élément nécessaire au fonctionnement du dispositif. Il saura également prévoir des éléments propres à éviter tout couplage capacitif entre l'inductance et d'autres éléments formés dans la même puce de circuit intégré.

## Revendications

1. Inductance réalisée dans une puce de circuit intégré, **caractérisée en ce qu**'elle est constituée d'une pluralité de lignes conductrices (L1, L2, L3, L4, L5, L6) parallèles entre elles, de largeur optimisée, chaque ligne conductrice étant formée dans l'épaisseur d'au moins une couche isolante (20, 23, 27), ces lignes étant interconnectées par au moins un segment conducteur perpendiculaire (25).

2. Inductance selon la revendication 1, **caractérisée en ce que** la largeur optimisée est égale au double de l'épaisseur de peau correspondant à la fréquence maximale d'un courant haute fréquence passant dans ladite inductance.

3. Inductance selon la revendication 1 ou 2, **caractérisée en ce que** les lignes conductrices (L1, L2, L3, L4, L5, L6) sont formées dans trois couches isolantes (20, 23, 27) et **en ce que** les segments conducteurs sont formés dans au moins une des trois couches isolantes (23).

4. Procédé de formation d'une inductance sous forme monolithique, **caractérisé en ce qu**'il comporte l'étape consistant à former dans au moins une couche isolante (23), le long du motif de l'inductance, une pluralité de lignes conductrices parallèles (L1, L2, L3, L4, L5, L6) et des segments perpendiculaires auxdites lignes (25) et les interceptant toutes.

5. Procédé selon la revendication 4, **caractérisé en ce que** les lignes conductrices (L1, L2, L3, L4, L5, L6) ont une largeur égale au double de l'épaisseur de peau correspondant à la fréquence maximale d'un courant haute fréquence destiné à passer dans l'inductance.

6. Procédé selon la revendication 4, **caractérisé en ce qu**'une quelconque étape de formation et/ou d'extension de lignes conductrices (L1, L2, L3, L4, L5, L6) dans une couche isolante (20, 23, 27) comporte les étapes suivantes :
creuser dans la couche isolante considérée des tranchées (24, 25) selon le motif souhaité ;
déposer une couche d'un matériau conducteur (22, 26, 28) de façon à remplir les tranchées précédemment formées ; et
procéder à un polissage mécano-chimique, de façon à éliminer ledit matériau conducteur de la surface supérieure de ladite couche isolante considérée, d'où il résulte que le matériau conducteur ne demeure en place que dans les tranchées précédemment formées.

7. Procédé selon la revendication 6, **caractérisé en ce que** le matériau conducteur (22, 26, 28) est métallique.

8. Procédé selon la revendication 7, **caractérisé en ce que** le matériau conducteur (22, 26, 28) est du cuivre ou un alliage à base de cuivre.

## Claims

1. An inductance formed in an integrated circuit chip, **characterized in that** it is formed of a plurality of parallel conductive lines (L1, L2, L3, L4, L5, L6) of optimized width, each conductive line being formed in the thickness of at least one insulating layer (20, 23, 27), these lines being interconnected by at least one perpendicular conductive segment (25) .

2. The inductance of claim 1, **characterized in that** the optimized width is equal to twice the skin thickness corresponding to the maximum frequency of a high-frequency current running through said inductance.

3. The inductance of claim 1 or 2, **characterized in that** the conductive lines (L1, L2, L3, L4, L5, L6) are formed in three insulating layers (20, 23, 27) and the conductive segments are formed in at least one of the three insulating layers (23).

4. A method for forming an inductance in monolithic form, **characterized in that** it includes the step of forming in at least one insulating layer (23), along an inductance pattern, a plurality of parallel conductive lines (L1, L2, L3, L4, L5, L6) and segments perpendicular to said lines (25) and intercepting all of them.

5. The method of claim 4, **characterized in that** the conductive lines (L1, L2, L3, L4, L5, L6) have a width equal to twice the skin thickness corresponding to the maximum frequency of a high-frequency current intended to be conducted by the inductance.

6. The method of claim 4, **characterized in that** any step of forming and/or extension of conductive lines (L1, L2, L3, L4, L5, L6) in an insulating layer (20, 23, 27) includes the steps of:
digging, into the considered insulating layer, trenches (24, 25) according to the desired pattern;
depositing a layer of a conductive material (22, 26, 28) to fill the trenches; and
performing a chem-mech polishing, to remove said conductive material from the upper surface of said considered insulating layer, whereby the conductive material only remains in place in the previously-formed trenches.

7. The method of claim 6, **characterized in that** the conductive material (22, 26, 28) is a metal.

8. The method of claim 7, **characterized in that** the conductive material (22, 26, 28) is copper or a copper-based alloy.

## Patentansprüche

1. Eine Induktanz, die in einem integrierten Schaltkreis-Chip gebildet ist, **dadurch gekennzeichnet, dass** sie aus einer Vielzahl von parallelen leitenden Leitungen (L1, L2, L3, L4, L5, L6) von optimierter Breite gebildet ist, wobei jede leitende Leitung in der Dicke von wenigstens einer isolierenden Schicht (20, 23, 27) gebildet ist, wobei diese Leitungen zusammengeschaltet sind, durch wenigstens ein lotrechtes leitendes Segment (25).

2. Induktanz nach Anspruch 1, **dadurch gekennzeichnet, dass** die optimierte Breite gleich ist dem doppelten der Skin- bzw. Oberflächendicke entsprechend der maximalen Frequenz eines hochfrequenten Stroms, der durch die Induktanz fließt.

3. Induktanz nach Anspruch 1 oder 2, **gekennzeichnet dadurch, dass** die leitenden Leitungen (L1, L2, L3, L4, L5, L6) in drei isolierenden Schichten (20, 23, 27) gebildet sind und die leitenden Segmente in wenigstens einer von den drei isolierenden Schichten (23) gebildet sind.

4. Ein Verfahren zum Bilden einer Induktanz in monolithischer Form, **dadurch gekennzeichnet, dass** es den Schritt des Bildens in wenigstens einer isloierenden Schicht (23), entlang eines Induktanz-Musters, einer Vielzahl von parallelen leitenden Leitungen (L1, L2, L3, L4, L5, L6) und Segmenten lotrecht zu den Leitungen (25) und alle davon abfangend, beinhaltet.

5. Verfahren nach Anspruch 4, **dadurch gekennzeichnet, dass** die leitenden Leitungen (L1, L2, L3, L4, L5, L6) eine Breite besitzen, die gleich dem doppelten der Oberflächendicke entsprechend der maximalen Frequenz eines hochfrequenten Stroms ist, der durch die Induktanz geleitet werden soll.

6. Verfahren nach Anspruch 4, **dadurch gekennzeichnet, dass** jeder Schritt des Bildens und/oder der Extension von leitenden Leitungen (L1, L2, L3, L4, L5, L6) in einer isolierenden Schicht (20, 23, 27) die folgenden Schritte beinhaltet:
Graben, in die berücksichtigte Isolierschicht, von Gräben (24, 25) gemäß dem gewünschten Muster;
Abscheiden einer Schicht eines leitenden Materials (22, 26, 28), um die Gräben zu füllen; und
Durchführen eines chemisch-mechanischen Polierens, zum Entfernen des leitenden Materials von der oberen Oberfläche der berücksichtigen Isolierschicht, wobei das leitende Material nur in den vorher gebildeten Gräben an Ort und Stelle verbleibt.

7. Verfahren nach Anspruch 6, **dadurch gekennzeichnet, dass** das leitende Material (22, 26, 28) ein Metall ist.

8. Verfahren nach Anspruch 7, **dadurch gekennzeichnet, dass** das leitende Material (22, 26, 28) Kupfer oder eine kupferbasierte Legierung ist.
